# EUROPEAN PATENT APPLICATION

(11) **EP 3 243 794 A1**
(43) Date of publication of application: **15.11.2017**
(21) Application number: 16168895.7
(22) Date of filing: 10.05.2016
(51) Int. Cl.: B82Y 10/00, B82Y 15/00, H01L 21/02, H01L 29/66, H01L 27/146, H01L 29/16

(54) **A METHOD OF MAKING AN ARRAY OF SENSOR PIXELS, AND ASSOCIATED APPARATUS AND METHODS**

(71) Applicant: Emberion Oy, 02130 Espoo (FI)
(72) Inventor: Bower, Chris, Ely, CB6 3EN (GB); White, Richard, Huntingdon, PE28 9DY (GB); Liu, Yinglin, Cambridge, CB1 3SA (GB); Rushton, Ashley, Herts, SG8 7QT (GB)
(74) Representative: Boco IP Oy Ab

(57) **Abstract**

A method (Fig. 4) of making an array of sensor pixels, the method comprising:
- forming an array of nucleation sites (415) on a growth substrate (Step 2), each nucleation site configured to facilitate the growth of a respective domain of channel material on the growth substrate and the array of nucleation sites having a predefined configuration corresponding to an arrangement of pixel regions on a target substrate;
- growing an array of domains (416) of channel material on the growth substrate from the array of respective nucleation sites to form a layer of channel material (step 3); - transferring the layer of channel material onto the target substrate such that the domains of channel material are substantially aligned with the pixel regions of the target substrate (step 6), to allow the formation of a pixel array.

Each pixel (Fig. 1) of the array comprises source (101) and drain (102) electrodes configured to enable a flow of electrical current through a respective domain of channel material (103), and a functionalising material (104) on the domain of channel material configured to produce a detectable change in the flow of electrical current on exposure to a physical stimulus which is indicative of one or more of the presence and magnitude of the physical stimulus.
In particular, the channel material (103) may be graphene or another two-dimensional material, and the functionalising material (104) may be quantum dots (107).

## Description

### Technical Field

The present disclosure relates particularly to sensors, associated methods and apparatus. Certain embodiments specifically concern a method of making an array of sensor pixels comprising: forming an array of nucleation sites on a growth substrate; growing an array of domains of channel material on the growth substrate from the array of respective nucleation sites to form a layer of channel material; and transferring the layer of channel material onto a target substrate such that the domains of channel material are substantially aligned with pixel regions of the target substrate.

Some embodiments may relate to portable electronic devices, in particular, so-called hand-portable electronic devices which may be hand-held in use (although they may be placed in a cradle in use). Such hand-portable electronic devices include so-called Personal Digital Assistants (PDAs) and tablet PCs. The portable electronic devices/apparatus according to one or more disclosed example aspects/embodiments may provide one or more audio/text/video communication functions (e.g. telecommunication, video-communication, and/or text transmission, Short Message Service (SMS)/ Multimedia Message Service (MMS)/emailing functions, interactive/non-interactive viewing functions (e.g. web-browsing, navigation, TV/program viewing functions), music recording/playing functions (e.g. MP3 or other format and/or (FM/AM) radio broadcast recording/playing), downloading/sending of data functions, image capture function (e.g. using a (e.g. in-built) digital camera), and gaming functions.

### Background

Research is currently being done to develop new sensors and methods of making the same.

The listing or discussion of a prior-published document or any background in this specification should not necessarily be taken as an acknowledgement that the document or background is part of the state of the art or is common general knowledge.

### Summary

According to a first aspect, there is provided a method of making an array of sensor pixels, the method comprising:
forming an array of nucleation sites on a growth substrate, each nucleation site configured to facilitate the growth of a respective domain of channel material on the growth substrate, the array of nucleation sites having a predefined configuration corresponding to an arrangement of pixel regions on a target substrate;
growing an array of domains of channel material on the growth substrate from the array of respective nucleation sites to form a layer of channel material; and
transferring the layer of channel material onto the target substrate such that the domains of channel material are substantially aligned with the pixel regions of the target substrate to allow the formation of a pixel array, each pixel of the array comprising source and drain electrodes configured to enable a flow of electrical current through a respective domain of channel material, and a functionalising material on the domain of channel material configured to produce a detectable change in the flow of electrical current on exposure to a physical stimulus which is indicative of one or more of the presence and magnitude of the physical stimulus.

The domains of channel material may be grown using chemical vapour deposition, and the nucleation sites may comprise a plurality of discrete regions of seed material formed on the growth substrate.

The channel material may comprise graphene, and the seed material may comprise one or more of a carbon-based material and a catalyst material.

The carbon-based material may comprise one or more of graphene and poly(methyl methacrylate).

The catalyst material may comprise one or more of copper, nickel, platinum and silicon carbide.

The catalyst material may form all or part of the growth substrate.

The channel material may comprise one or more of graphene, graphene oxide, reduced graphene oxide, a graphene-like material, and a transition metal dichalcogenide.

The graphene-like material may comprise one or more of phosphorene, silicene, germanene, stanene, GaN, InN, InP, InAs, BAs and GaP.

The transition metal dichalcogenide may comprise one or more of WX₂, MoX₂, ScX₂, TiX₂, HfX₂, ZrX₂, VX₂, CrX₂, MnX₂, FeX₂, CoX₂, NiX₂, NbX₂, TcX₂, ReX₂, PdX₂ and PtX₂, where X = S, Se or Te.

The nucleation sites may have a spacing therebetween which is an integer multiple of the spacing between the pixel regions.

The method may comprise forming one or more alignment markers on the growth substrate to guide formation of the nucleation sites.

The one or more alignment markers may be configured to complement one or more respective registration markers on the target substrate to facilitate alignment of the domains of channel material with the pixel regions.

The growth substrate may comprise a layer of catalyst material configured to facilitate growth of the channel material, and the one or more alignment markers may be formed by removing regions of the catalyst material such that the resulting layer of channel material comprises one or more alignment holes therein.

The one or more alignment markers may be formed by depositing an optically opaque material on the growth substrate which is substantially inert throughout the growth of the channel material.

Each domain of channel material may comprise one or more single-crystal grains, and the domains of channel material may be aligned with the pixel regions of the target substrate to at least one of:
position the largest single-crystal grains on the pixel regions; and
minimise the average number of single-crystal grains per pixel region.

At least one domain of channel material may comprise two or more single-crystal grains separated by grain boundaries, and the domains of channel material may be aligned with the pixel regions of the target substrate such that the grain boundaries are substantially parallel to the direction of current flow between the source and drain electrodes.

The method may comprise controlling one or more growth conditions such that the domains of channel material have substantially irregular edges.

The method may comprise controlling one or more growth conditions such that one or more of the size and geometry of the domains of channel material are substantially the same as the size and geometry of the pixel regions.

The method may comprise controlling one or more growth conditions such that any grain boundaries formed between adjacent single-crystal grains within the domains of channel material are substantially parallel to the direction of current flow between the source and drain electrodes.

The method may comprise controlling one or more growth conditions such that the domains of channel material have a generally square, hexagonal, circular or irregular shape.

The one or more growth conditions may comprise at least one of temperature, flow rate, time, surface roughness and surface oxygen content.

The target substrate may comprise one or more electronic components positioned between adjacent pixel regions configured to enable operation of the pixel array.

The one or more electronic components may comprise thin film transistors for addressing respective pixels of the pixel array.

The method may comprise controlling one or more growth conditions such that the domains of channel material merge together to form a continuous layer of channel material.

The method may comprise patterning the continuous layer of channel material after transfer of the layer of channel material to the target substrate to inhibit crosstalk between adjacent pixels.

The method may comprise using one or more of a vision system, mechanical positioners and an alignment algorithm to facilitate alignment of the domains of channel material with the pixel regions of the target substrate.

The vision system may comprise one or more of optical microscopy, scanning electron microscopy and Raman spectroscopy.

The target substrate may comprise preformed source and drain electrodes in each pixel region.

The target substrate may comprise a preformed gate electrode in each pixel region configured to enable the electrical conductivity of the domain of channel material to be tuned by a voltage applied to the gate electrode.

The preformed source and drain electrodes may have an enclosed-cell electrode geometry configured to inhibit crosstalk between adjacent pixels.

The method may comprise forming respective source and drain electrodes on top of the domains of channel material after transfer of the layer of channel material to the target substrate.

The source, drain and gate electrodes may comprise one or more of a metal, a metal nanoparticle ink, silver, gold, copper, nickel, cobalt, palladium, a conductive metal oxide, a carbon-based material, an organic material and a polymer.

The method may comprise depositing a layer of carrier material on top of the layer of channel material, and then removing the growth substrate, before transfer of the layer of channel material to the target substrate.

The layer of carrier material may comprise one or more of poly(methyl methacrylate), polycarbonate, polyimide and parylene.

The layer of channel material may be transferred to the target substrate by wet transfer from solution, or by dry transfer using one or more of a pressure-sensitive adhesive, a heat-release adhesive and a UV-release adhesive.

The physical stimulus may be electromagnetic radiation, and the functionalising material may comprise one or more of a quantum dot material and a Perovskite material configured to generate electron-hole pairs on exposure to the electromagnetic radiation which produce a detectable change in the flow of electrical current.

The Perovskite material may comprise one or more of methylammonium tin (CH₃NH₃PbX₃) and a lead halide (e.g. CH₃NH₃SnX₃).

The physical stimulus may be a charged species, and the functionalising material may comprise a receptor species configured to bind to the charged species such that the charged species is in sufficient proximity to the domain of channel material to produce a detectable change in the flow of electrical current.

According to a further aspect, there is provided a method of making an array of sensor pixels, the method comprising:
forming an array of nucleation sites having a predefined configuration corresponding to an arrangement of pixel regions of a target substrate, each nucleation site configured to facilitate the growth of a respective domain of channel material; and
growing an array of domains of channel material from the array of respective nucleation sites to allow the formation of a pixel array, each pixel of the array comprising source and drain electrodes configured to enable a flow of electrical current through a respective domain of channel material, and a functionalising material on the domain of channel material configured to produce a detectable change in the flow of electrical current on exposure to a physical stimulus which is indicative of one or more of the presence and magnitude of the physical stimulus.

The array of nucleation sites may be formed on a growth substrate, and the array of domains of channel material may be grown on the growth substrate to form a layer of channel material. The method may further comprise transferring the layer of channel material onto the target substrate such that the domains of channel material are substantially aligned with the pixel regions of the target substrate.

The array of nucleation sites may be formed on the corresponding pixel regions of the target substrate, and the array of domains of channel material may be grown on the target substrate from the array of respective nucleation sites.

According to a further aspect, there is provided an apparatus formed by any method described herein.

The apparatus may be one or more of an electronic device, a portable electronic device, a portable telecommunications device, a mobile phone, a personal digital assistant, a tablet, a phablet, a desktop computer, a laptop computer, a server, a smartphone, a smartwatch, smart eyewear, a sensor, and a module for one or more of the same.

According to a further aspect, there is provided an apparatus comprising an array of sensor pixels,
each pixel comprising a domain of channel material, source and drain electrodes configured to enable a flow of electrical current through the domain of channel material, and a functionalising material on the domain of channel material configured to produce a detectable change in the flow of electrical current on exposure to a physical stimulus which is indicative of one or more of the presence and magnitude of the physical stimulus,
wherein the domain of channel material of each pixel comprises no more than 5 single-crystal grains.

According to a further aspect, there is provided a method of detecting a physical stimulus using an apparatus,
the apparatus comprising an array of sensor pixels, each pixel comprising a domain of channel material, source and drain electrodes configured to enable a flow of electrical current through the domain of channel material, and a functionalising material on the domain of channel material configured to produce a detectable change in the flow of electrical current on exposure to a physical stimulus which is indicative of one or more of the presence and magnitude of the physical stimulus, wherein the domain of channel material of each pixel comprises no more than 5 single-crystal grains,
the method comprising determining one or more of the presence and magnitude of the physical stimulus based on a detectable change in the flow of electrical current through the domain of channel material of at least one pixel.

The steps of any method disclosed herein do not have to be performed in the exact order disclosed, unless explicitly stated or understood by the skilled person.

Corresponding computer programs for implementing one or more steps of the methods disclosed herein are also within the present disclosure and are encompassed by one or more of the described example embodiments.

One or more of the computer programs may, when run on a computer, cause the computer to configure any apparatus, including a battery, circuit, controller, or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

One or more of the computer programs may be provided on a computer readable medium, which may be a physical computer readable medium such as a disc or a memory device, or may be embodied as a transient signal. Such a transient signal may be a network download, including an internet download.

The present disclosure includes one or more corresponding aspects, example embodiments or features in isolation or in various combinations whether or not specifically stated (including claimed) in that combination or in isolation. Corresponding means for performing one or more of the discussed functions are also within the present disclosure.

The above summary is intended to be merely exemplary and non-limiting.

### Brief Description of the Figures

A description is now given, by way of example only, with reference to the accompanying drawings, in which:-
Figure 1 shows a photodetector apparatus comprising a quantum dot field-effect transistor;
Figures 2 A1-A3 show an existing method of making an array of sensor pixels;

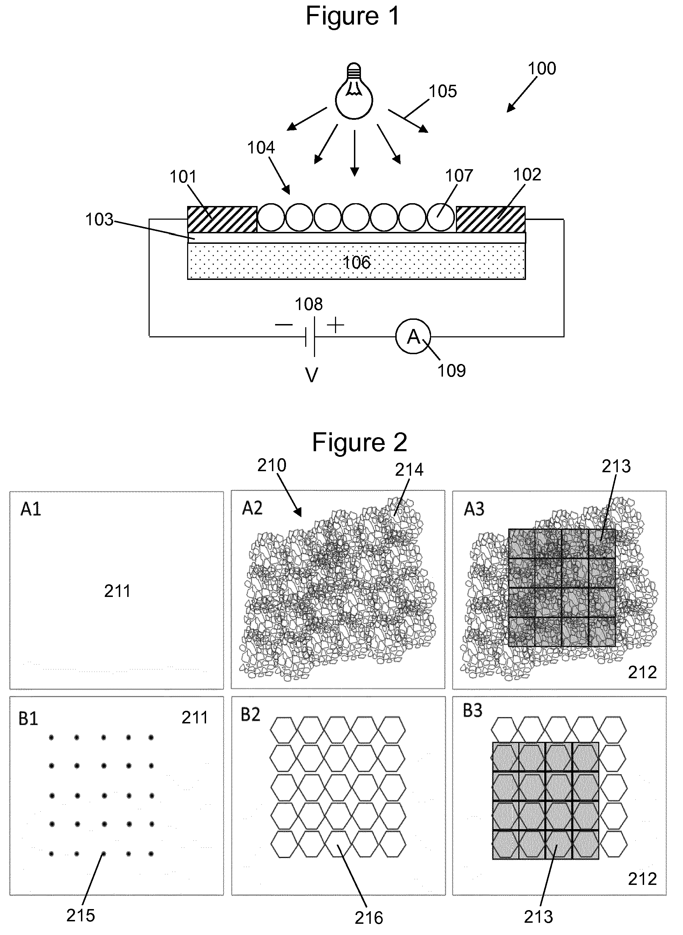

Figures 2 B1-B3 show a new method of making an array of sensor pixels;

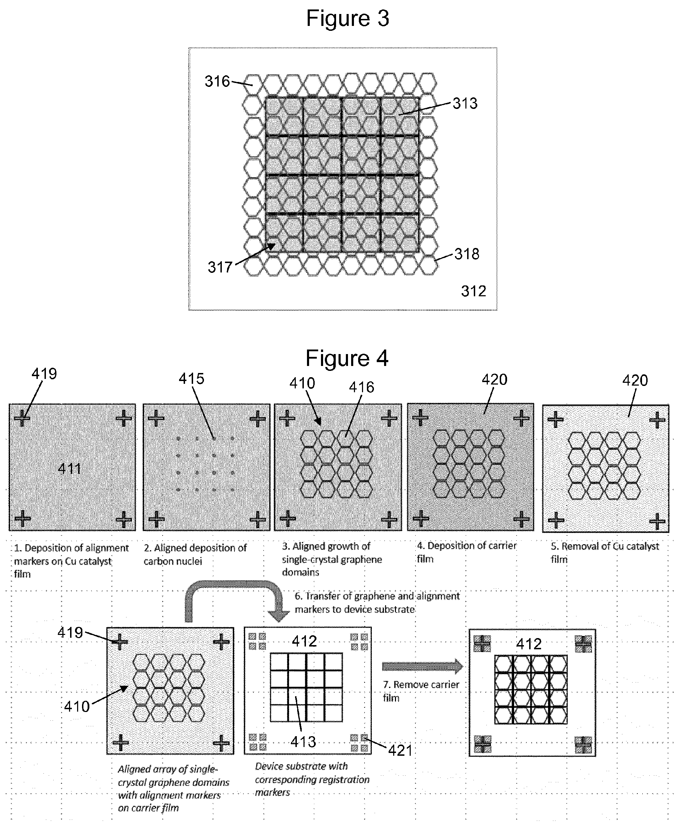

Figure 3 shows an array of sensor pixels comprising an integer number of domains of channel material per pixel;
Figure 4 shows the use of alignment markers to facilitate alignment of the domains of channel material with the pixel regions;

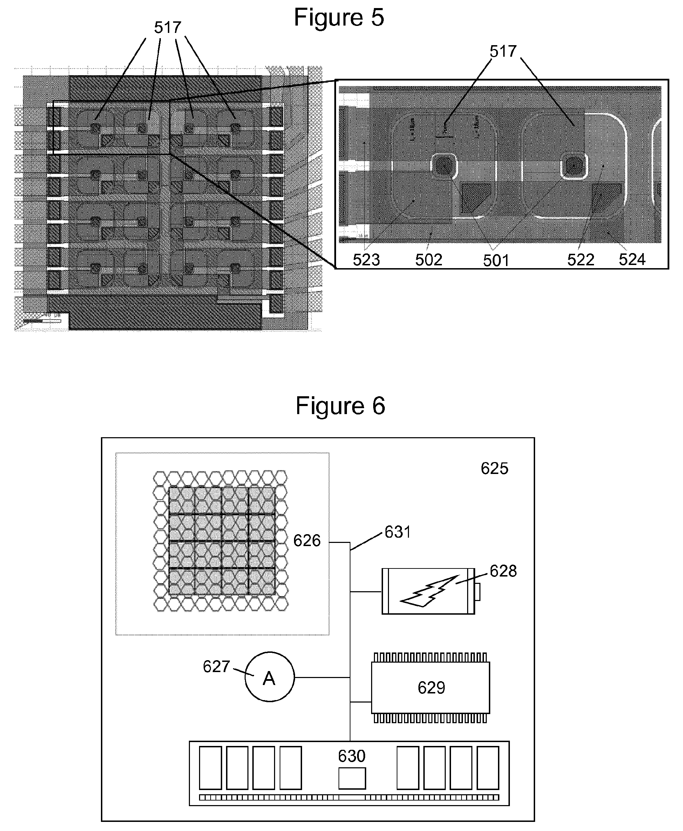

Figure 5 shows a plurality of pixels in plan view having an enclosed-cell electrode geometry;
Figure 6 shows an apparatus comprising an array of sensor pixels;

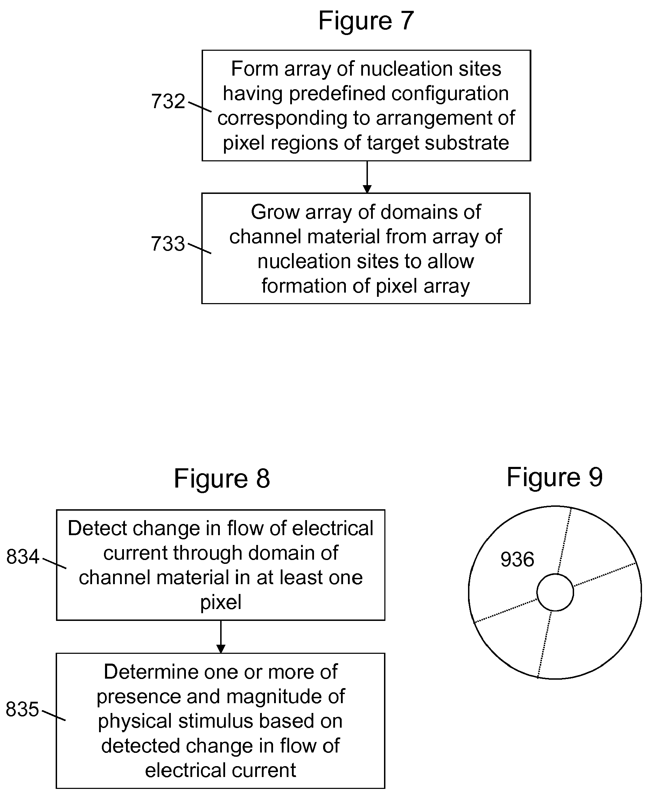

Figure 7 shows the main steps of a method of making an array of sensor pixels;
Figure 8 shows the main steps of a method of detecting a physical stimulus using an apparatus comprising an array of sensor pixels; and
Figure 9 shows a computer-readable medium comprising a computer program configured to perform, control or enable a method described herein.

### Description of Specific Aspects/Embodiments

Field-effect transistors can form the basis of many different types of sensor depending on the specific functionalising material incorporated into the structure. For example, photodetectors can be formed by incorporating a quantum dot or Perovskite material configured to enable the detection of incident electromagnetic radiation, whilst chemical or biological sensors can be formed by incorporating a receptor species configured to enable the detection of a particular analyte species.

Figure 1 shows a photodetector 100 comprising a quantum dot field-effect transistor. Field-effect transistors typically comprise source 101 and drain 102 electrodes configured to enable a flow of electrical current through a channel 103 between the source 101 and drain 102 electrodes, and a gate electrode (not shown) configured to vary the electrical current flowing through the channel 103 when a voltage is applied thereto. To enable photodetection, however, a layer of quantum dot material 104 is used to vary the electrical current instead of the gate electrode (although the gate electrode may be retained to tune the conductivity of the channel 103).

The layer of quantum dot material 104 is formed on top of the channel 103 (which itself is supported on a substrate 106) and comprises a plurality of quantum dots 107 configured to generate electron-hole pairs on exposure to the incident electromagnetic radiation 105. The photodetector 100 is configured such that, after the generation of these electron-hole pairs, either the electrons or the holes are transferred to the channel 103 leaving the remaining charge carriers on the quantum dots 107. These remaining charge carriers then gate the channel 103 causing a detectable change in the current flowing therethrough.

The photodetector apparatus 100 shown in Figure 1 also comprises a power supply 108 configured to apply a potential difference V between the source 101 and drain 102 electrodes, and an ammeter 109 configured to measure the electrical current flowing through the channel 103.

If the quantum dot material 104 is supplemented by a Perovskite material, the wavelength sensitivity of the quantum dot material 104 can be tuned to the visible or infrared region of the electromagnetic spectrum.

In the case of a chemical or biological sensor, the layer of quantum dot material 104 is replaced by a receptor species configured to bind to a charged analyte species such that the charged analyte species is in sufficient proximity to the channel 103 to produce a detectable change in the flow of electrical current.

There is currently interest in graphene as a channel material because of its high charge carrier mobility and sensitivity to applied field. There are a number of different ways to form a graphene layer. Chemical vapour deposition (CVD) on a catalyst surface is the most effective method of fabricating high quality large area crystalline graphene suitable for use in field-effect devices. This involves three main stages. Firstly, the catalyst (e.g. copper, nickel or platinum) is annealed at high temperature (e.g. 1000°C) in a hydrogen rich atmosphere to remove the native oxide on the copper surface. Secondly, a carbon precursor (e.g. methane) is introduced which forms small graphene islands to initiate the graphene growth. Thirdly, these islands increase in size as the reaction progresses and eventually merge together to form a continuous graphene layer.

Once the continuous graphene layer has been grown, it is typically transferred from the catalyst/growth substrate onto a target substrate comprising an array of predefined pixel regions defining the footprint of the sensor pixels, after which it is patterned into a plurality of respective channels to prevent crosstalk between adjacent pixels. In some cases, the pixel regions may comprise respective preformed gate electrodes positioned beneath the graphene channel. Source and drain electrodes are then formed on top of each channel followed by the deposition of a functionalising material. Each "pixel" may therefore be considered to comprise a functionalised field-effect transistor with or without associated electrical connections.

Figures 2A1-A3 illustrate the formation of a continuous layer of graphene 210 (A2) on a catalyst surface 211 (A1) via CVD followed by transfer of the graphene layer 210 onto a target substrate 212 (A3) comprising a plurality of square pixel regions 213. As shown in Figures 2A2 and 2A3, the graphene layer 210 formed in this way tends to comprise a relatively large number of small randomly oriented grains 214 with a correspondingly large number of grain boundaries per pixel region 213 (e.g. 25 grains per 50µm x 50µm pixel region). The presence of grain boundaries reduces the charge carrier mobility of the graphene, and hence, lowers the performance of the sensor. It should be noted that this issue is not limited solely to graphene, but can also affect other channel materials formed using CVD or similar growth techniques.

Figures 2B1-B3 illustrate an alternative fabrication method for making an array of sensor pixels. The method comprises forming an array of nucleation sites 215 on the growth substrate 211 (B1), each nucleation site 215 configured to facilitate the growth of a respective domain/region 216 of channel material on the growth substrate 211. The array of nucleation sites 215 have a predefined configuration corresponding to an arrangement of pixel regions 213 on the target substrate 212. Once the nucleation sites 215 have been formed, an array of domains 216 of channel material are grown on the growth substrate 211 from the array of respective nucleation sites 215 to form the layer of channel material 210 (B2). The layer of channel material 210 is then transferred onto the target substrate 212 such that the domains 216 of channel material are substantially aligned with the pixel regions 213 of the target substrate 212 (B3).

Each domain 216 of channel material comprises one or more single-crystal grains 214. Since the domains 216 are grown from nucleation sites 215 which have an arrangement corresponding to the pixel regions 213, the channel formed in each pixel region 213 comprises fewer grains 214 and grain boundaries than channels formed without the use of predefined nucleation sites 215. This increases the charge carrier mobility within the channel resulting in improved device performance.

In practice, the domains 216 of channel material would typically be aligned with the pixel regions 213 of the target substrate 212 to position the largest single-crystal grains 214 on the pixel regions 213 and/or minimise the average number of single-crystal grains 214 per pixel region 213. If any of the domains 216 of channel material comprise two or more single-crystal grains separated by grain boundaries, the domains 216 may (additionally or alternatively) be aligned with the pixel regions 213 of the target substrate 212 such that the grain boundaries are substantially parallel to the direction of current flow between the source and drain electrodes. In this way, no grain boundaries need to be crossed by the charge carriers resulting in a greater mobility.

Furthermore, one or more growth conditions (e.g. temperature, flow rate, time, surface roughness and surface oxygen content) may be controlled such that at least one of the size and geometry of the domains 216 of channel material are substantially the same as the size and geometry of the pixel regions 213. In this scenario, there is no need to pattern the layer of channel material after transfer because the domains 216 form discrete regions on the target substrate 212 rather than a continuous layer. In other examples, however, the growth conditions may be controlled such that the domains 216 of channel material merge together to form a continuous layer of channel material which can be subsequently patterned.

When CVD is used to grow the domains 216 of channel material, the nucleation sites 215 may comprise a plurality of discrete regions of seed material formed on the growth substrate 211. For example, when the channel material comprises graphene, the seed material may comprise one or more of a carbon-based material and the catalyst material itself. Any carbon-based material that is converted to pure carbon upon heating to temperatures of around 1000 °C would be suitable as a seed material (e.g. graphene, a hydrocarbon, or a polymer such as PMMA). The seed material can deposited onto the growth substrate 211 as a continuous layer and subsequently etched to form the nucleation sites 215, it can be deposited through a predefined mask to form the nucleation sites 215, or it can be deposited using an additive printing method (such as inkjet, flexographic, pad, offset, intaglio, rotary screen or screen printing). A carbon-based material initiates graphene growth by providing a small single-crystal of carbon which can then be grown to form a larger domain 216. For example, the seeds for graphene growth may be created by selectively etching a monolayer of graphene to leave small seed regions having the desired spatial separation. The use of graphene as a seed material avoids the creation of multilayer graphene at the seed location which can occur when using PMMA. A catalyst material, on the other hand, initiates growth via heterogeneous nucleation to form domains 216 of graphene which are centred at the nucleation sites 215. For example, the seeds for graphene growth can be created by removing portions of the growth catalyst substrate 211 (e.g. copper foil or layer of copper on a Si wafer) to leave copper in the desired growth areas.

Alternative channel materials include reduced graphene oxide, a graphene-like material (e.g. phosphorene, silicene, germanene, stanene, GaN, InN, InP, InAs, BAs and GaP) or a transition metal dichalcogenide (e.g. WX₂, MoX₂, ScX₂, TiX₂, HfX₂, ZrX2, VX₂, CrX₂, MnX₂, FeX₂, CoX₂, NiX₂, NbX₂, TcX₂, ReX₂, PdX₂ and PtX₂, where X = S, Se or Te). Each of these materials may be formed as two-dimensional films and exhibit structural and electrical properties which render them suitable for use in field-effect transistor-based sensors.

Figure 3 shows an array of sensor pixels 317 on a target substrate 312 comprising an integer number of domains 316 of channel material per pixel region 313. Ideally, each domain 316 should comprise one large single-crystal grain that covers the entire active area of the pixel region 313. To achieve this, very low concentrations of the precursor should be used during growth, preferably in combination with a smooth growth substrate (e.g. an electro-polished substrate). These factors also help to ensure that the channel material grows only at the nucleation sites.

The formation of one grain per pixel region 313 is not essential, however. In order to limit the number of grain boundaries within each pixel region 313, the nucleation sites should have a spacing therebetween which is an integer multiple of the spacing between the pixel regions 313. In this way, the edges of each domain 316 typically align more closely with the edges of the respective pixel region 313. Suitable growth conditions for graphene include: a growth pressure in the range of 2-200Pa; a growth temperature in the range of 950-1050°C; an Ar flow rate of 0-100 sccm; a H₂ flow rate of 25-100 sccm; a CH₄ flow rate of 0.1-0.5 sccm; and a growth time of 10-300mins. Under these conditions, a 50µm x 50µm pixel region 313 would typically comprises no more than 5 single crystal grains with an average grain size (diameter) of 10µm.

The growth conditions can also be chosen such that the shape of the domains 316 facilitates alignment of the domain/pixel edges (e.g. square domains rather than hexagonal domains 316 for better alignment with the square pixel regions 313 in Figure 3). The possible domain shapes include generally square, hexagonal, circular or irregular geometries. In additional to controlling the overall shape of the domains 316, it is also possible to control the shape of the domain edges 318 by varying the growth conditions. In Figure 3, the domains 316 of channel material have straight well-defined edges 318. In some cases, however, it may be desirable to form domains 316 with more irregular edges 318 (without necessarily altering the overall shape of the domains 316). Irregular edges can be used to increase the edge-line contact of the domain 316 of channel material with the source and drain electrodes (not shown) which reduces the contact resistance. This is because charge injection into the channel is improved if the edges of the channel are accessible to the electrodes. For graphene domains, rough edges can be achieved by exposing the regions of the growth substrate where domain edges are likely to be formed to oxygen gas before the graphene is grown. Suitable parameters for this step include an oxygen flow rate of 1-10sccm for 10-300s. The growth conditions may also be chosen such that any grain boundaries between adjacent single-crystal grains within the domains 316 (i.e. if polycrystalline domains are formed) are substantially parallel to the direction of current flow between the source and drain electrodes.

As mentioned above, once the layer of channel material has been grown, it is transferred onto the target substrate such that the domains of channel material are substantially aligned with the pixel regions. To help ensure that the domains of channel material are capable of being aligned with the pixel regions, one or more alignment markers may be formed on the growth substrate to guide formation of the nucleation sites. The one or more alignment markers may be formed by depositing an optically opaque material on the growth substrate which is substantially inert throughout the growth of the channel material (i.e. does not change phase or form intermetallic compounds with the catalyst material). Suitable examples for graphene growth include refractory metals such as Mo and W. Additionally or alternatively, the one or more alignment markers may be formed by removing regions of the catalyst material (e.g. by laser cutting) such that the resulting layer of channel material comprises one or more alignment holes therein.

The one or more alignment markers may be configured to complement one or more respective registration markers on the target substrate. Furthermore, during the transfer step, at least one of a vision system (e.g. optical microscopy, scanning electron microscopy or Raman spectroscopy), mechanical positioners and an alignment algorithm may be used to facilitate alignment of the domains of channel material with the pixel regions of the target substrate.

Figure 4 shows one example of alignment markers 419 being used to facilitate alignment of the domains 416 of channel material with the pixel regions 413. First, metallic alignment markers 419 are deposited onto the growth substrate 411, which in this example, is a copper foil catalyst (although it could be a layer of copper deposited on top of another substrate such as a silicon wafer). An array of carbon-based nucleation sites 415 corresponding to the arrangement of pixel regions 413 on the target substrate 412 is then formed using the alignment markers 419 as a guide. Once the nucleation sites 415 have been formed, an array of graphene domains 416 are grown on the catalyst material 411 from the respective nucleation sites 415 to form a layer of channel material 410. A layer of carrier material 420 (e.g. a polymeric material such as PMMA, polycarbonate, polyimide or parylene) is then deposited on top of the channel material 410 to enable transfer of the channel material 410 to the target substrate 412, followed by removal of the copper catalyst 411. An electrochemical process, or a chemical etchant such as ferric chloride or ammonium persulfate solution, can be used to remove the copper foil 411 without removing the alignment markers 419. The layer of channel material 410 (graphene), together with the metallic alignment markers 419, is then transferred to the target substrate 412 via the carrier film 420 (e.g. by wet transfer from solution or by dry transfer using one or more of a pressure-sensitive adhesive, a heat-release adhesive and a UV-release adhesive). In order to align the graphene domains 416 with the pixel regions 413, the alignment markers 419 are aligned with corresponding registration markers 421 on the target substrate 412. The layer of carrier material 420 is then removed (e.g. by etching or delamination) to complete the transfer process. If the domains 416 of channel material form a continuous layer, the continuous layer can be patterned to form an array of discrete channels/domains 416 after it has been transferred to the target substrate 412. As mentioned previously, however, the growth conditions may be controlled such that the domains 416 form discrete regions on the growth substrate 411 without the need for subsequent patterning after transfer.

Once the layer of channel material 410 has been transferred to the target substrate 412 (and divided into respective channels, if necessary), source and drain electrode pairs can be formed to enable a flow of electrical current through each domain 416 of channel material followed by the deposition of a functionalising material onto the respective domains 416. The electrodes may be formed by depositing a continuous layer of electrically conductive material (e.g. via evaporation or sputtering) and subsequently etching the continuous layer through a predefined mask into discrete electrodes. Alternatively, the electrode material may be deposited through a predefined mask to define the discrete electrodes. The electrode material may comprise one or more of a metal, a metal nanoparticle ink, silver, gold, copper, nickel, cobalt, palladium, a conductive metal oxide, a carbon-based material, an organic material and a polymer. The functionalising material may be deposited onto the domains 416 of channel material through a predefined mask using any suitable printing or coating process. The functionalising material may comprise any material which is capable of interacting with the physical stimulus to produce a detectable change in electrical current, such as one or more of a quantum dot and Perovskite material for the detection of electromagnetic radiation or a receptor species for the detection of a charged chemical or biological species.

In the examples described above, a layer of channel material (comprising the array of domains) is grown on a growth substrate and subsequently transferred onto the target substrate such that the domains of channel material are substantially aligned with the pixel regions of the target substrate. In other examples, however, the array of nucleation sites may be formed on the corresponding pixel regions of the target substrate (e.g. deposited onto the centre of each pixel region) such that the array of domains of channel material can be grown on the target substrate from the array of respective nucleation sites. Although this approach avoids the additional carrier and transfer steps, the other materials used to form the apparatus must be able to withstand the high growth temperature of the channel material, which limits the choice of materials that can be used.

Rather than forming the electrodes on top of the layer of channel material 410, the electrodes (together with their respective electrical connections) may be pre-formed on the target substrate 412 before the layer of channel material 410 is transferred. This approach allows generic electrode modules to be manufactured for use in various different field-effect devices, and also limits the number of lithographic processing steps performed on the sensitive channel material 410. In some cases, electrically conductive material may also be deposited on top of the channel material 410 in register with the underlying electrodes to improve the electrical contact by sandwiching the channel material 410 therebetween.

Furthermore, it is important that the pixels are electrically isolated from one another in order to avoid crosstalk. Rather than patterning a continuous layer of channel material to divide it into a plurality of discrete channels/domains, the source and drain (and possibly gate) electrodes may be configured to define the respective pixels and inhibit a flow of electrical current therebetween. This allows a continuous layer of channel material to be used which is common to some or all of the pixels.

Figure 5 shows a plurality of pixels 517 in plan-view having an enclosed-cell electrode geometry, and an enlarged view showing greater detail of two adjacent pixels 517. Each pixel 517 comprises a source electrode 501 configured to provide a source of charge carriers, a drain electrode 502 configured to provide a current sink for the charge carriers, and a gate electrode 522 configured to tune the conductivity of the domain of channel material between the source electrode 501 and the drain electrode 502. The enlarged view also shows source routing 523 and gate routing 524 to/from the respective source 501 and gate 522 electrodes.

The drain electrode 502 of each pixel 517 forms a substantially continuous in-plane perimeter which substantially encloses both the source electrode 501 and the gate electrode 522 when viewed from above the electrode plane. This structure serves to inhibit the flow of charge carriers from the source electrode 501 of a pixel 517 beyond the drain electrode 502 of that pixel 517. Thus charge carriers introduced via the source electrode 501 flow generally radially to the drain electrode 502 defining the outer perimeter of the pixel 517. Furthermore, in this example, the same drain electrode 502 surrounds the source 501 and gate 522 electrodes of each of the different pixels 517 and is therefore common to all pixels 517 of the sensor (although in other examples, it may only be common to a subset of these pixels 517). This configuration simplifies fabrication of the apparatus because it allows a continuous layer of conductive material to be used for the drain electrode 502.

It will be appreciated by those skilled in the art that the source 501 and drain 502 electrodes in Figure 5 could be reversed such that the source electrode 501 defines the perimeter of each pixel 517 rather than the drain electrode 502. Another electrode configuration which could be used to inhibit crosstalk between adjacent pixels 517 is an interdigitated electrode geometry (not shown). With this geometry, the source electrode may comprise a linear portion, and the drain electrode may comprise two parallel connected linear portions positioned on either side of the linear portion of the source electrode. As with the enclosed-cell electrode geometry, the drain electrode may be common to all pixels. In this scenario, the drain electrode may comprise three or more parallel connected linear portions configured to complement the respective linear portions of the source electrodes. As also mentioned in relation to the enclosed-cell electrode geometry, the source and drain electrodes could be reversed and still inhibit crosstalk.

In some cases, the spaces between adjacent pixels on the target substrate may be used to site other sensor components configured to enable operation of the pixel array. For example, a respective thin film transistor may be positioned adjacent each pixel for addressing that particular pixel of the array. This feature makes better use of the space available on the target substrate thus facilitating miniaturisation of the sensor device.

Figure 6 shows an apparatus 625 comprising an array 626 of sensor pixels. The apparatus 625 may be one or more of an electronic device, a portable electronic device, a portable telecommunications device, a mobile phone, a personal digital assistant, a tablet, a phablet, a desktop computer, a laptop computer, a server, a smartphone, a smartwatch, smart eyewear, a sensor, and a module for one or more of the same. In the example shown, the apparatus 625 comprises an array 626 of sensor pixels formed using the method described herein, an ammeter 627, a power supply 628, a processor 629 and a storage medium 630, which are electrically connected to one another by a data bus 631.

The processor 629 is configured for general operation of the apparatus 625 by providing signalling to, and receiving signalling from, the other components to manage their operation. The storage medium 630 is configured to store computer code configured to perform, control or enable operation of the apparatus 625. The storage medium 630 may also be configured to store settings for the other components. The processor 629 may access the storage medium 630 to retrieve the component settings in order to manage the operation of the other components.

Under the control of the processor 629, the power supply 628 is configured to apply a voltage between the source and drain electrodes of each pixel to enable a flow of electrical current through the respective channel. In addition, the power supply 628 may be configured to apply a further voltage to the gate electrode to tune the conductivity of the channel.

The ammeter 627 is configured to measure the electrical current through the channel so that any change in current caused by the physical stimulus can be determined. Based on the change in electrical current, the processor 629 is configured to determine one or more of the presence and magnitude of the physical stimulus. In order to determine the presence/magnitude of the physical stimulus, the processor 629 may use predetermined calibration data saved in the storage medium 630 which correlates the magnitude of physical stimulus (e.g. intensity of electromagnetic radiation or concentration of charged analyte species) with the change in current.

The processor 629 may be a microprocessor, including an Application Specific Integrated Circuit (ASIC). The storage medium 630 may be a temporary storage medium such as a volatile random access memory. On the other hand, the storage medium 630 may be a permanent storage medium such as a hard disk drive, a flash memory, or a non-volatile random access memory. The power supply 628 may comprise one or more of a primary battery, a secondary battery, a capacitor, a supercapacitor and a battery-capacitor hybrid.

Figure 7 shows schematically the main steps 732-733 of a method of making an array of sensor pixels. The method generally comprises: forming an array of nucleation sites having a predefined configuration corresponding to an arrangement of pixel regions of a target substrate 732; and growing an array of domains of channel material from the array of respective nucleation sites to allow the formation of a pixel array 733.

Figure 8 shows schematically the main steps 834-835 of a method of using a photodetector apparatus. The method generally comprises: detecting a change in the flow of electrical current through the domain of channel material of at least one pixel 834; and determining one or more of the presence and magnitude of the physical stimulus based on the detected change in the flow of electrical current 835.

Figure 9 illustrates schematically a computer/processor readable medium 936 providing a computer program according to one embodiment. The computer program may comprise computer code configured to perform, control or enable one or more of the method steps 732-835 of Figure 7 or 8. In this example, the computer/processor readable medium 936 is a disc such as a digital versatile disc (DVD) or a compact disc (CD). In other embodiments, the computer/processor readable medium 936 may be any medium that has been programmed in such a way as to carry out an inventive function. The computer/processor readable medium 936 may be a removable memory device such as a memory stick or memory card (SD, mini SD, micro SD or nano SD).

Other embodiments depicted in the figures have been provided with reference numerals that correspond to similar features of earlier described embodiments. For example, feature number 1 can also correspond to numbers 101, 201, 301 etc. These numbered features may appear in the figures but may not have been directly referred to within the description of these particular embodiments. These have still been provided in the figures to aid understanding of the further embodiments, particularly in relation to the features of similar earlier described embodiments.

It will be appreciated to the skilled reader that any mentioned apparatus/device and/or other features of particular mentioned apparatus/device may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/functional units.

In some embodiments, a particular mentioned apparatus/device may be pre-programmed with the appropriate software to carry out desired operations, and wherein the appropriate software can be enabled for use by a user downloading a "key", for example, to unlock/enable the software and its associated functionality. Advantages associated with such embodiments can include a reduced requirement to download data when further functionality is required for a device, and this can be useful in examples where a device is perceived to have sufficient capacity to store such pre-programmed software for functionality that may not be enabled by a user.

It will be appreciated that any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).

It will be appreciated that any "computer" described herein can comprise a collection of one or more individual processors/processing elements that may or may not be located on the same circuit board, or the same region/position of a circuit board or even the same device. In some embodiments one or more of any mentioned processors may be distributed over a plurality of devices. The same or different processor/processing elements may perform one or more functions described herein.

It will be appreciated that the term "signalling" may refer to one or more signals transmitted as a series of transmitted and/or received signals. The series of signals may comprise one, two, three, four or even more individual signal components or distinct signals to make up said signalling. Some or all of these individual signals may be transmitted/received simultaneously, in sequence, and/or such that they temporally overlap one another.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/embodiments may consist of any such individual feature or combination of features. In view of the foregoing description it will be evident to a person skilled in the art that various modifications may be made within the scope of the disclosure.

While there have been shown and described and pointed out fundamental novel features as applied to different embodiments thereof, it will be understood that various omissions and substitutions and changes in the form and details of the devices and methods described may be made by those skilled in the art without departing from the spirit of the invention. For example, it is expressly intended that all combinations of those elements and/or method steps which perform substantially the same function in substantially the same way to achieve the same results are within the scope of the invention. Moreover, it should be recognized that structures and/or elements and/or method steps shown and/or described in connection with any disclosed form or embodiment may be incorporated in any other disclosed or described or suggested form or embodiment as a general matter of design choice. Furthermore, in the claims means-plus-function clauses are intended to cover the structures described herein as performing the recited function and not only structural equivalents, but also equivalent structures. Thus although a nail and a screw may not be structural equivalents in that a nail employs a cylindrical surface to secure wooden parts together, whereas a screw employs a helical surface, in the environment of fastening wooden parts, a nail and a screw may be equivalent structures.

## Claims

1. A method of making an array of sensor pixels, the method comprising:
forming an array of nucleation sites having a predefined configuration corresponding to an arrangement of pixel regions of a target substrate, each nucleation site configured to facilitate the growth of a respective domain of channel material; and
growing an array of domains of channel material from the array of respective nucleation sites to allow the formation of a pixel array, each pixel of the array comprising source and drain electrodes configured to enable a flow of electrical current through a respective domain of channel material, and a functionalising material on the domain of channel material configured to produce a detectable change in the flow of electrical current on exposure to a physical stimulus which is indicative of one or more of the presence and magnitude of the physical stimulus.

2. The method of claim 1, wherein the array of nucleation sites are formed on a growth substrate, and the array of domains of channel material are grown on the growth substrate to form a layer of channel material, the method further comprising:
transferring the layer of channel material onto the target substrate such that the domains of channel material are substantially aligned with the pixel regions of the target substrate.

3. The method of claim 1, wherein the array of nucleation sites are formed on the corresponding pixel regions of the target substrate, and the array of domains of channel material are grown on the target substrate from the array of respective nucleation sites.

4. The method of any preceding claim, wherein the nucleation sites have a spacing therebetween which is an integer multiple of the spacing between the pixel regions.

5. The method of claim 2 or any claim depending therefrom, wherein the method comprises forming one or more alignment markers on the growth substrate to guide formation of the nucleation sites.

6. The method of claim 5, wherein the one or more alignment markers are configured to complement one or more respective registration markers on the target substrate to facilitate alignment of the domains of channel material with the pixel regions.

7. The method of claim 5 or 6, wherein the growth substrate comprises a layer of catalyst material configured to facilitate growth of the channel material, and wherein the one or more alignment markers are formed by removing regions of the catalyst material such that the resulting layer of channel material comprises one or more alignment holes therein.

8. The method of claim 5 or 6, wherein the one or more alignment markers are formed by depositing an optically opaque material on the growth substrate which is substantially inert throughout the growth of the channel material.

9. The method of claim 2 or any claim depending therefrom, wherein each domain of channel material comprises one or more single-crystal grains, and wherein the domains of channel material are aligned with the pixel regions of the target substrate to at least one of:
position the largest single-crystal grains on the pixel regions; and
minimise the average number of single-crystal grains per pixel region.

10. The method of any preceding claim, wherein the method comprises controlling one or more growth conditions such that the domains of channel material have substantially irregular edges.

11. The method of any preceding claim, wherein the method comprises controlling one or more growth conditions such that one or more of the size and geometry of the domains of channel material are substantially the same as the size and geometry of the pixel regions.

12. The method of any preceding claim, wherein the method comprises controlling one or more growth conditions such that any grain boundaries formed between adjacent single-crystal grains within the domains of channel material are substantially parallel to the direction of current flow between the source and drain electrodes.

13. The method of any preceding claim, wherein the target substrate comprises one or more electronic components positioned between adjacent pixel regions configured to enable operation of the pixel array.

14. The method of claim 2 or any claim depending therefrom, wherein the method comprises using one or more of a vision system, mechanical positioners and an alignment algorithm to facilitate alignment of the domains of channel material with the pixel regions of the target substrate.

15. An apparatus comprising an array of sensor pixels,
each pixel comprising a domain of channel material, source and drain electrodes configured to enable a flow of electrical current through the domain of channel material, and a functionalising material on the domain of channel material configured to produce a detectable change in the flow of electrical current on exposure to a physical stimulus which is indicative of one or more of the presence and magnitude of the physical stimulus,
wherein the domain of channel material of each pixel comprises no more than 5 single-crystal grains.
